Europäisches Patentamt

European Patent Office

Office européen des brevets

(11) Numéro de publication : **0 500 448 A1**

(19)

(12) # DEMANDE DE BREVET EUROPEEN

(21) Numéro de dépôt : **92400421.1**

(51) Int. Cl.⁵ : **G01R 29/12,** G01R 1/067

(22) Date de dépôt : **18.02.92**

(30) Priorité : **19.02.91 FR 9101932**

(43) Date de publication de la demande :
**26.08.92 Bulletin 92/35**

(84) Etats contractants désignés :
**DE GB IT**

(71) Demandeur : **THOMSON-CSF**
**51, Esplanade du Général de Gaulle**
**F-92800 Puteaux (FR)**

(72) Inventeur : **Landesman, Jean-Pierre**
**THOMSON-CSF, SCPI, Cédex 67**
**F-92045 Paris la Défense (FR)**
Inventeur : **Friederich, Alain**
**THOMSON-CSF, SCPI, Cédex 67**
**F-92045 Paris la Défense (FR)**
Inventeur : **Stéphan, Ronan**
**THOMSON-CSF, SCPI, Cédex 67**
**F-92045 Paris la Défense (FR)**

(74) Mandataire : **Guérin, Michel et al**
**THOMSON-CSF SCPI**
**F-92045 PARIS LA DEFENSE CEDEX 67 (FR)**

(54) **Capteur de champ électrique sensible aux champs faibles.**

(57)    L'invention concerne un capteur de champ électrique, sensible aux champs faibles, comprenant un film mince de matériau ferroélectrique sur lequel sont déposées des paires d'électrodes. Ce capteur comprend en outre des moyens de mesure de la capacité du condensateur constitué par le matériau et les paires d'électrodes, et des moyens pour générer une onde acoustique dans le matériau.
    Application : Détection sous-marine.

FIG.3

EP 0 500 448 A1

La présente invention se rapporte aux capteurs de champ électrique qui permettent de mesurer un champ électrique continu ou variant avec une très faible fréquence même si le champ à mesurer est de faible intensité.

Ce type de dispositif prend une importance croissante liée aux nouveaux critères de détention fondés sur les champs continus ou quasicontinus associés aux navires.

En effet, ces dernier devienent de plus en plus silencieux acoustiquement oui magnétiquement avec les contre-mesures mises en oeuvre.

Une des méthodes à ce jour pour détecter un champ continu consiste à procéder de manière directe en se rapportant à la définition du champ électrique. On sait en effet que le champ électrique E existant entre deux points séparés par une distance d est égal au rapport entre la différence du potentiel V entre ces deux points et cette distance. C'est-à-dire E = V/d. La mesure de V entre deux électrodes conduit directement à la valeur du champ. Une expérience a été réalisée avec un capteur fondé sur la mesure de la circulation du champ électrique le long du segment constitué par l'intervalle d'espace séparant les deux électrodes. On accède ainsi à la connaissance de la valeur moyenne du champ électrique sur le segment, long de 1 à 2m, joignant les électrodes, avec une sensibilité meilleure que 1 $\mu Vm^{-1}Hz^{-1/2}$. Malgré cette sensibilité performante, les problèmes liés à l'encombrement, à la difficulté d'obtenir un parallélisme bien contrôlé des deux électrodes en regard et à la nécessité d'établir la circulation du champ le long d'un parcours conducteur, limitent beaucoup le domaine d'application de ce type de capteur.

Un autre type de capteur a été proposé, donnant une mesure directe et ponctuelle de la valeur du champ électrique à mesurer. Ce capteur utilise un noyau de matériau ferroélectrique disposé entre deux électrodes que l'on soumet à un champ de polarisation alternatif à la fréquence f qui lui fait décrire un cycle d'hystérésis allant jusqu'à saturation dans les deux sens du cycle. Le champ continu ou quasicontinu à mesurer s'ajoutant au champ de polarisation entraîne une dissymétrie du cycle d'hystéréris que décrit la polarisation en fonction du champ électrique. En absence de champ extérieur, la courbe P=f (E) ou P polarisation et E champ électrique est une fonction impaire dont la transformée en série de Fourier ne donne que des harmoniques impaires. La présence d'un champ électrique externe créant la dissymétrie de la courbe génère des harmoniques paires. L'analyse du signal à la fréquence 2f aux bornes du matériau ferroélectrique conduit à la mesure électrique extérieure.

Selon ce principe de mesure des capteurs à base de pérovskites de plomb ont pu être réalisés. Ils présentent une épaisseur de l'ordre de 200 $\mu m$, un diamètre d'électrodes de 6mm environ et une sensibilité de $10^{-4}V.m^{-1}.Hz^{-1/2}$. Ils fournissent une mesure ponctuelle du champ mais avec une sensibilité devant être améliorée.

La sensibilité dur capteur est dépendante de la capacité du condensateur formée et plus la capacité de la sonde est élevée, plus on arrive à détecter des champs faibles. Pour cela une solution consiste à diminuer l'épaisseur du matériau ferroélectrique, jusqu'à l'obtention d'un film d'épaisseur très faible. Cependant dans un tel cas de figure, un autre paramètre revêt une importance prépondérante. Il s'agit d'un champ dit. dépolarisant $E_1$ qui nait de la polarisation P du matériau. En effet, lorsqu'un matériau polarisable est soumis à un champ extérieur, il apparaît sur les parois de ce matériau des charges surfaciques et le champ électrique $E_1$ généré par ces charges dépend de la polarisation avec un facteur dépolarisant N défini comme suit : $E_{1i} = \dfrac{NiPi}{\varepsilon_o}$ (avec i=x,y ou z directions dans l'espace ).

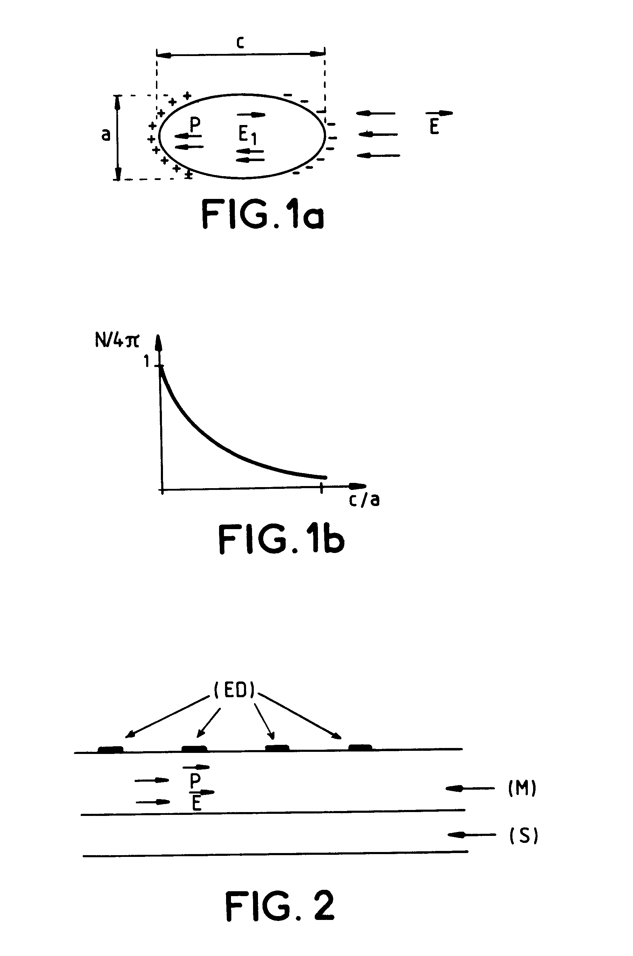

Dans le cas général où le matériau a une géométrie en ellipse la figure 1 montre l'influence du rapport c/a sur le paramètre N.

c étant l'axe de l'ellipse parallèle au champ a étant l'axe de l'ellipse perpendiculaire au champ

Dans le cas d'un film mince où le champ extérieur à mesurer est perpendiculaire au plan du film, le facteur dépolarisant est égal à 1, ce qui revient à dire qu'un tel capteur n'est pas du tout sensible à un tel champ.

Pour pallier ce problème de champ dépolarisant et réaliser un capteur sensible aux champs électriques faibles, l'invention propose la réalisation d'un capteur comprenant une sonde comportant un film mince de matériau ferroélectrique sur lequel sont déposées des électrodes, et des moyens pour mesurer la capacité du condensateur formé par ce matériau et les électrodes (ED), le matériau étant de préférence déposé sur un substrat (S).

Une telle configuration présente l'avantage de mesurer la composante du champ parallèle au plan du film, composante qui n'est pas dépolarisée.

Dans la présente invention, le nombre de paires d'électrodes peut être variable, notamment si le champ à mesurer possède une fréquence basse mais non nulle, on peut disposer des paires d'électrodes toutes les longueurs d'onde de ce champ pour conduire à une meilleure précision de la mesure.

Les moyens de mesure peuvent comprendre des moyens faisant propager dans le plan du film une onde acoustique capable de polariser périodiquement le matériau et des moyens pour mesurer la polarisation résultante toutes les demi périodes de l'onde acoustique.

L'invention sera mieux comprise et d'autres avantages apparaîtront grâce à la description qui va suivre, donnée à titre non limitatif, accompagnée des dessins annexés parmi lesquels :

    – La figure 1 illustre l'incidence la géométrie d'un matériau polarisable sur le facteur dépolarisant.

    La figure 1a représente un éllipsoïde de matériau polarisable et l'orientation des champs extérieur et dépolarisant.

    La figure 1b montre l'évolution du facteur dépolarisant N avec la géométrie du matériau.

    – La figure 2 représente la sonde de matériau ferroélectrique avec ses électrodes, selon l'invention,

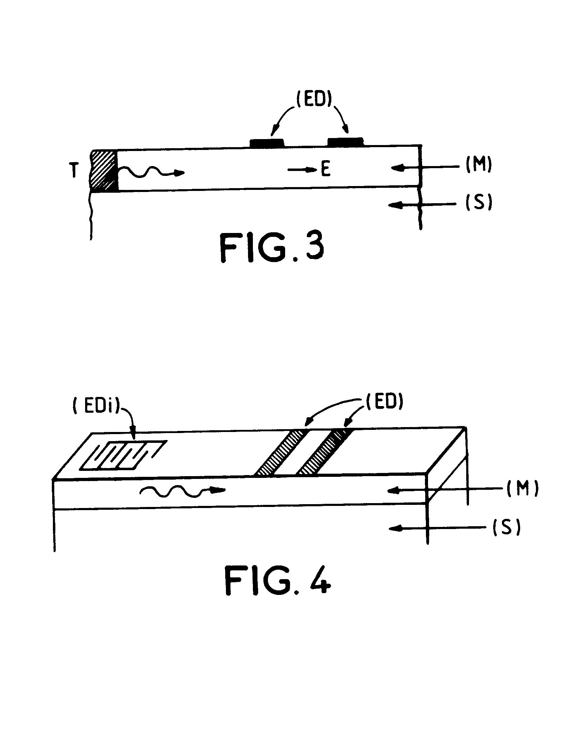

    – La figure 3 illustre un exemple de capteur selon l'invention dans laquelle l'onde acoustique est introduite par un transducteur T.

    – la figure 4 illustre un autre exemple de capteur selon l'invention dans laquelle l'onde acoustique est générée par l'intermédiaire du peigne d'électrodes interdigitées.

Dans le capteur selon l'invention, on fait propager une onde acoustique dans le matériau férroélectrique. Pour cela on utilise de préférence un élément transducteur (T) accolé à une extrémité du film (figure 6), il peut s'agir d'un barreau de matériau photoréfractif. On peut également employer un peigne d'électrodes interdigitées ($ED_i$) (figure 7) déposées par métallisation à une extrémité du film de matériau férroélectrique.

Le principe de la mesure repose sur la détermination de la capacité C (t) prises entre les électrodes (ED). A un instant t la polarisation dans l'espace inter électrode est P et la capacité C (t) ; une demi période T/2 de l'onde acoustique plus tard la polarisation est inversée soit - P et la capacité mesurée C(t+T/2). En l'absence de composante de champ électrique E dans le plan du film, ces deux capacités sont égales. Par contre, la présence d'urne composante $E_{ox}$ dans le plan entraîne une différence entre ces deux capacités, qui sera détectée par le circuit de mesure.

Cette différence proportionnelle au champ électrique à mesurer permet par étalonnage la détermination de ce champ électrique.

Un tel dispositif présente l'avantage d'une électronique de mesure très simple.

Dans les différents dispositifs proposés, il est nécessaire d'avoir un film mince réalisé à partir d'un matériau ferroélectrique ayant la plus forte constante diélectrique possible pour avoir la meilleure sensibilité possible. C'est pourquoi les matériaux employés peuvent être des matériaux céramiques à structures pérovskite du type $Pb (Zr, Ti) O_3$ appelé PZT ou de type $(Pb, La) (Zr, Ti)O_3$ appelé PLZT qui ont des constantes diélectriques qui peuvent atteindre plusieurs milliers. De plus, de tels matériaux ont des coefficients de couplage piézoélectrique forts qui en font de bons candidats pour le dispositif à onde acoustique.

Les films minces utilisés dans un capteur selon l'invention peuvent être réalisés par dépôt du matériau ferroélectrique sur un substrat, en orientant l'axe tétragonal de la structure dans le plan du film mince, dans lequel il est nécessaire d'avoir la constante diélectrique élevée. Cette situation est réalisée lorsque l'on fait croître le PZT sur un cristal de silicium on peut aussi envisager d'employer du $Pb (Mn, Nb) O_3$ sur de l'oxyde de manganèse MnO.

Pour cela les dépôts peuvent être effectués selon plusieurs procédés :

    il peut s'agir d'un dépôt sous vide par évaporation d'une cible unique (en matériau céramique) ou de plusieurs cibles contenant chacune un des éléments à évaporer. Des variantes de cette technique existent, telles que la pulvérisation réactive (utilisation d'un plasma pour bombarder les cibles plutôt qu'un faisceau d'électrons), ou la pulvérisation par faisceaux d'ions.

Ce dépôt peut également être réalisé par voie chimique, par exemple par la méthode Sol-Gel. Pour cela on prépare une solution avec des composés organiques des différents métaux (par exemple des alkoxydes), solution qui est ensuite étalée sur le substrat puis séchée et enfin recuite sous air. L'intérêt de ce type de dépôt réside bien sûr dans la simplicité de mise en oeuvre.

## Revendications

1. Capteur de champ électrique sensible aux champs faibles, comprenant une sonde comportant un film mince de matériau ferroélectrique (M) sur lequel sont disposées une ou plusieurs paires d'électrodes (ED), caractérisé en ce qu'il comprend des moyens pour faire propager dans le film mince de matériau, une onde acoustique capable de polariser périodiquement ce matériau et des moyens pour mesurer la capacité du condensateur formé toutes les demi-périodes de l'onde acoustique, dont la dissymétrie introduite par le champ électrique extérieur à mesurer permet de déterminer la valeur de ce champ électrique.

2. Capteur selon la revendication 1, caractérisé en ce que les moyens pour faire propager l'onde acoustique comportent un transducteur accolé au film mince.

3. Capteur selon la revendication 1, caractérisé en ce que les moyens pour faire propager l'onde acoustique comportent un peigne d'électrodes interdigitées (EDi) déposées à une extrémité du film, les électrodes (ED) étant déposées sur une autre région du film de matériau ferroélectrique.

FIG.1a

FIG.1b

FIG. 2

FIG.3

FIG. 4

EP 0 500 448 A1

**Office européen des brevets**

# RAPPORT DE RECHERCHE EUROPEENNE

Numero de la demande

EP 92 40 0421

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | SOVIET INVENTIONS ILLUSTRATED Derwent Publications Ltd., Section Mechanical, abrégé no. 128222, S01, semaine 8718, 13 mai 1987; & SU - A - 1257569 (MOSC POWER INST) --- | 1 | G 01 R 29/12 G 01 R 1/067 |
| A | JAPANESE JOURNAL OF APPLIED PHYSICS vol. 26, no. 7, juillet 1987, pages 1039-1045, Tokyo, JP; T. FURUKAWA et al.: "Measurements of Nonlinear Dielectricity in Ferroelectric Polymers" * page 1040, colonne de gauche, lignes 4-41; page 1041, colonne de droite, ligne 15 - page 1043, ligne 16; figures 4-6 * --- | 1 | |
| A | JOURNAL OF APPLIED PHYSICS vol. 64, no. 11, 1 décembre 1988, pages 6445-6451, New York, US; Q.M. ZHANG et al.: "Domain wall excitations and their contributions to the weak-signal response of doped lead zirconate titanate ceramics" * page 6446, colonne de gauche, lignes 20-31; figure 1 * --- | 1 | |
| A | REVIEW OF SCIENTIFIC INSTRUMENTS vol. 50, no. 5, mai 1979, pages 595-601, New York, US; V.R. YARBERRY et al.: "Automated system for electrical field-polarization studies in ferroelectrics" * abrégé; figures 1-3 * --- -/- | 1 | |

**DOMAINES TECHNIQUES RECHERCHES (Int. Cl.5)**

G 01 R
H 01 G
H 01 L
G 01 N
G 01 V
H 01 C
C 23 C

Le présent rapport a été établi pour toutes les revendications

| Lieu de la recherche | Date d'achèvement de la recherche | Examinateur |
|---|---|---|
| BERLIN | 03-05-1992 | FRITZ S C |

Office européen
des brevets

**RAPPORT DE RECHERCHE EUROPEENNE**

Numero de la demande

EP   92 40 0421

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | PROCEEDINGS IEEE 1987 ULTRASONCIS SYMPOSIUM vol. 2, 14-16 October 1987, pages 741-745, Denver, Colorado, US; R. LEC et al.: "Influence of an External Electric Field on the Electroacoustic Properties of PZT-4" * le document en entier * | 1 | |
| A | ELECTRONICS LETTERS vol. 26, no. 14, 5 juillet 1990, pages 973-975, Stevanage, GB; A.V. MEDVED et al.: "Highly Sensitive Electrostatic Voltage Sensor on SAW Double-Waveguides" * page 973, colonne de droite, ligne 1 - page 974, colonne de gauche, ligne 11; figure 1 * | 1-3 | |
| A | EP-A-0 187 309  (K.K. MEIDENSHA) * page 29, ligne 2 - page 30, ligne 12; figures 12-14 * | 1 | |
| A | EP-A-0 237 250  (MATSUSHITA ELECTRIC INDUSTRIAL CO.) * revendications 1-4; figure 1 * | 1 | **DOMAINES TECHNIQUES RECHERCHES (Int. Cl.5)** |
| A | IEEE TRANSACTIONS ON ULTRASONICS, FERROELECTRICS AND FREQUENCY CONTROL vol. 37, no. 5, septembre 1990, pages 333-338, New York, US; S.G. YOON et al.: "Characterization and Electrical Properties of Chemical Vapor Deposited Ferroelectric Lead Titanate Films on Titanium" * page 333, colonne de gauche, ligne 1 - colonne de droite, ligne 3; abrégé *    -/- | 1 | |

Le présent rapport a été établi pour toutes les revendications

| Lieu de la recherche | Date d'achèvement de la recherche | Examinateur |
|---|---|---|
| BERLIN | 03-05-1992 | FRITZ S C |

| | Office européen des brevets | **RAPPORT DE RECHERCHE EUROPEENNE** | Numero de la demande |

EP 92 40 0421

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 510 443 (R. INABA et al.) <br> * abrégé; figure 2; colonne 4, lignes 13-28 * | 1-3 | |

DOMAINES TECHNIQUES RECHERCHES (Int. Cl.5)

Le présent rapport a été établi pour toutes les revendications

| Lieu de la recherche | Date d'achèvement de la recherche | Examinateur |
|---|---|---|
| BERLIN | 03-05-1992 | FRITZ S C |